# EUROPEAN PATENT SPECIFICATION

(11) **EP 1 554 763 B1**
(45) Date of publication and mention of the grant of the patent: **02.08.2006**
(21) Application number: 03807898.6
(22) Date of filing: 25.08.2003
(51) Int. Cl.: H01L 45/00, H01L 27/24

(54) **ELECTRIC DEVICE COMPRISING PHASE CHANGE MATERIAL**
ELEKTRISCHE EINRICHTUNG MIT EINEM PHASENÄNDERUNGSMATERIAL
DISPOSITIF ELECTRIQUE CONTENANT UN MATERIAU A CHANGEMENT DE PHASE

(30) Priority: 11.10.2002 EP 02079220
(43) Date of publication of application: 20.07.2005
(73) Proprietor: Koninklijke Philips Electronics N.V., 5621 BA Eindhoven (NL)
(72) Inventor: LANKHORST, Martijn, H., R., NL-5656 AA Eindhoven (NL); DE THEIJE, Femke, K., NL-5656 AA Eindhoven (NL); MEINDERS, Erwin, R., NL-5656 AA Eindhoven (NL); WOLF, Ronald, M., NL-5656 AA Eindhoven (NL)
(74) Representative: Eleveld, Koop Jan
(86) International application number: PCT/IB2003/003865
(87) International publication number: WO 2004/034482

(56) References cited:
- EP-A- 1 318 552
- WO-A-00/39028
- WO-A-99/54128
- US-A- 5 825 046
- US-A1- 2002 134 995
- US-A1- 2003 146 469

## Description

The invention relates to an electric device with a body having a resistor comprising a phase change material which is able to be in a first phase and in a second phase, the resistor having a surface with a first contact area and a second contact area, the resistor having an electrical resistance between the first contact area and the second contact area, the electrical resistance having a first value when the phase change material is in the first phase and a second value when the phase change material is in the second phase, a first conductor electrically connected to the first contact area, a second conductor electrically connected to the second contact area, the first conductor, the second conductor and the resistor being able to conduct a current for heating of the phase change material to enable a transition from the first phase to the second phase, and a layer of a dielectric material for reducing a heat flow to other parts of the body during the heating.

US 5,825,046 discloses an electric device having a resistor that serves as a memory cell for storing data and the resistor comprises a mixture of active phase-change material and inactive dielectric material, which reduces the switching current requirements and improves the thermal stability of the stored data. The dielectric layer is a layer of insulating material, such as SiO2, Si3N4 and tellurium oxygen sulfide (e.g. TEOS).

WO-A 00/57,498 discloses an electric device having a resistor comprising a phase change material, which may be, e.g., Te₈₁Ge₁₅S₂As₂, Te₈₁Ge₁₅S₂Sb₂, or a material including Te, Ge, Sb and one or more transition metals TM in the ratio (TeₐGe_{b}Sb₁₀₀₋(a+b))_{c}TM_{100-c} where the subscripts are in atomic percentages, a is below 70 percent, b is above 5 percent and below 50 percent and c is between 90 and 99.99 percent. The phase change material is able to be in a first phase, which may be, e.g., crystalline, and it is able to be in a second phase, which may be, e.g., amorphous. Alternatively, the first phase or the second phase, or both, may be partly amorphous and partly crystalline, provided that the resistor with the phase change material in the first phase and the resistor with the phase change material in the second phase have different values of the electrical resistance.

The resistor is electrically connected to a first conductor and a second conductor such that the value of the electrical resistance can be measured. The first conductor and the second conductor may comprise, e.g., one or more of the following materials: titanium, titanium nitride, titanium aluminum nitride, titanium carbon nitride, titanium silicon, molybdenum, carbon, tungsten, and titanium tungsten.

The resistor, the first conductor and the second conductor are able to conduct a current which via heating enables transitions of the phase change material between the first phase and the second phase. It is believed that for a transition from a phase with a relatively good conductivity such as a crystalline phase or a mainly crystalline phase, to a phase with a relatively poor conductivity such as an amorphous phase or a mainly amorphous phase, heating by a sufficiently strong current causes melting of the phase change material. Said heating is achieved by the resistance of the first conductor, the second conductor and the resistor itself. Which one of the three elements contributes most to the heating depends in general on the materials and shapes of these elements. The heating ends when the current is switched off. The phase change material then quickly cools down and arranges itself in a more amorphous order.

When inducing a transition from a phase with a relatively low electric conductivity to a phase with a relatively high electric conductivity, the heating is initially counteracted by the poor conductivity, which makes it difficult to directly melt at least parts of the phase change material. It is believed that by applying a sufficient voltage across the resistor it is possible to locally induce an electrical breakdown in the phase change material, which leads to a high local current density and a higher current. The corresponding heating is then sufficient to increase the temperature of the phase change material above its crystallization temperature thereby enabling the phase transition. Depending on the heating power and the heating time a crystalline phase or at least a phase which is more crystalline than the phase before the transition is obtained.

The known electric device can be used as a resistor with an electrically adjustable resistance. This type of device may be used in all types of circuits and integrated circuits which require a resistor with a resistance switchable between a first value and a second value.

The known electric device is particularly suited for use as our electrically writable and erasable memory cell, which carries information encrypted in the value of the electrical resistance. In a two bit version, the memory cell is assigned, e.g., a "0" when the resistance is relatively low and a "1" when the resistance is relatively high. The resistance may be easily measured by supplying a voltage across the resistor and measuring the corresponding current. The memory element can be written and erased by inducing a transition from a first phase to a second phase as described above.

In a multi bit memory cell the phase change material is able to be in N different phases where N is an integer larger than two. In each of the N phases the resistance has a value characteristic of this particular phase. The value may therefore be used to assign the memory cell an integer M where M is not smaller than zero and not larger than N and where M uniquely characterizes the phase corresponding to the value.

When using the known electric device as a resistor with an electrically adjustable resistance it is often desired that the transition between the first phase and the second phase is as fast as possible and that it requires as little electric energy as possible. The first electric device of the kind described in the opening paragraph has switching times of several milliseconds and switching energies, i.e. the electric power required for enabling the phase transition multiplied by the switching time, of micro Joules. More advanced electric devices have switching times of several tens of nanoseconds and require switching powers of several pico Joules.

These improvements have been achieved by selecting phase change materials with better switching characteristics, by designing electric devices having a small volume of phase change material changed during a transition between the first phase and the second phase, and by using a layer of a dielectric material for thermally insulating the phase change material and thereby reducing the heat flow out of the phase change material. Silicon dioxide and silicon nitride have been used as dielectric materials.

It is a disadvantage of the known electric device that despite these improvements the switching power is still relatively high.

It is an object of the invention to provide an electric device of the kind described in the opening paragraph which operates at a relatively low switching power.

According to the invention the object is realized in that the dielectric material , which is not comprised in the resistor, comprises a porous material with pores having a size between 0.5 and 50 nm.

The invention is based on the insight that an electric device with dielectric material comprising a porous material has a reduced switching power, which is attributed to a lower heat conductivity of the porous material. Often, the pores are substantially spherical or cylindrical, the size of the pore is then defined by its diameter.

To actually obtain an electrical device with a reduced switching power it is essential that the pores are larger than 0.5 nm. Dielectric materials with smaller pores have the disadvantage that it is difficult to manufacture such materials having a porosity of more than 20 percent. Therefore, the thermal properties of the microporous materials are very similar to those of the corresponding bulk material which is free of pores. Preferably, the porosity is larger than 20 percent. Preferably, the porosity is larger than 45 percent. Preferably, the pores are larger than 1.0 nm.

Materials with pores larger than 50 nm have the disadvantage that due to the relatively large pore size it is virtually impossible to reliably manufacture an electric device with dimensions smaller than several hundreds of nm using one of these materials. For materials with pores larger than 50 nm it is difficult or even impossible to seal the pores, e.g. by a barrier layer. If there are pores larger than 50 nm it may happen that other materials used in the electric device such as, e.g., metals or the phase change material fill some of the pores. As a consequence the electric device may comprise layers of these other materials which have ill-defined dimensions leading to a malfunctioning electric device. In addition, or alternatively, it may happen that the pores of the macroporous material are not closed and that some or even all of the pores are filled by the other materials, which may lead to short-circuits.

The dielectric materials as used according to the invention are known as such in semiconductor manufacturing for their low dielectric constant which is lower than that of silicon dioxide. Because of this property, and despite the difficulties in processing them, these materials are used in integrated circuits which operate at frequencies where dielectrics with higher dielectric constants cannot be used anymore.

It is advantageous if the pores have a size between 1 and 10 nm because electric devices comprising a dielectric material with this pore size have a particularly low switching power.

In a preferred embodiment the porous material has pores substantially free of water. Experiments by the inventors indicated that in some cases the electric devices comprising porous material with pores not substantially free of water may disintegrate or delaminate when the phase change material is heated. These problems did not occur when the pores are substantially free of water.

In an electric device according to the invention the heat flow is reduced and therefore, the volume of the electric device heated during the phase transition is reduced as well. A reduced heated volume has an additional advantage when the electric device comprises more than one resistor which each comprise a phase change material. In these systems it is a well-known problem that by modifying the phase change material of one resistor the phase change material of another resistor may be unintentionally modified by a heat flow from the resistor to be changed to the other resistor. The chance of unintentionally modifying the phase change material of another resistor is reduced in an electric device according to the invention.

This effect, which is often referred to as crosstalk, is particularly prominent in arrays of electric devices used as a non-volatile memory, because in this case the mutual distance between the electric devices generally is relatively small and the advantage is particularly large.

A dielectric material with pores substantially free of water may be obtained by manufacturing an electric device comprising porous silicon dioxide or any other porous dielectric material including, e.g., titanium oxide, vanadium oxide or zirconium oxide and by subsequently treating the porous material by, e.g., heat and/or vacuum to remove substantially all water present.

It is advantageous if the pores have hydrophobic surfaces. In this case it is possible to expose the electric device during manufacture to an atmosphere which comprises water vapor. This is convenient because it is then not required to take precautions against possible water contamination of the atmosphere. During manufacture the electric device can be moved in normal clean room conditions.

Hydrophobic surfaces of the pores may be obtained, e.g., by using porous materials which are hydrophobic such as, e.g., porous SiLK™. This material is described in Waeterloos, J.J. et al., "Integration feasibility of porous SiLK semiconductor dielectric", in Proceedings of the IEEE 2001 International Interconnect Technology Conference, Burlingame, California, USA, 4-6 June 2001, p.253-4. It is marketed by Dow Chemical from Midland, Michigan, USA. Alternatively, a material as described in US-B1-6,352,945 and US-B1-6,383,955 may be used. An embodiment of this material is commercially available under the name Aurora™ which is marketed by ASM International from Bilthoven, the Netherlands.

It is advantageous if the porous material comprises an organosilicate and the hydrophobic surfaces have hydrocarbyl groups. Hydrocarbyl groups such as, e.g., alkyl groups and aryl groups are used to make the surfaces hydrophobic. As is known from WO-A 00/39028 the incorporation of these groups in the porous material to provide hydrophobic surfaces is accomplished conveniently when the porous material comprises an organosilicate

Example 5 of WO-A 00/39028 discloses a composition comprising tetraethoxyorthosilicate and methyltriethoxysilane in a ratio of 0.85:0.15. 10 lauryl ether, also referred to as (CH₂CH₂O)₁₀ C₁₂H₂₅OH, is used as a surfactant and a 50/50 mixture of water and ethanol is used as a solvent. Furthermore, hydrogen chloride is used as a catalyst. After aging, this composition is applied to silicon slices by means of spin-coating. The solvent and the acid are removed in a heating step, after which the surfactant is completely removed by calcination. Finally, a dehydroxylation process takes place by exposing the porous layer to a silane and subsequently to a vacuum treatment.

In an embodiment, the porous material is a material obtainable by applying a liquid layer of a composition comprising tetra-alkoxysilane, hydrocarbylalkoxysilane, a surfactant and a solvent onto a substrate, wherein the molar ratio between tetra-alkoxysilane and hydrocarbylalkoxysilane is 3:1 at the most, and heating the liquid layer to remove the surfactant and the solvent and to form the hydrophobic porous layer. Preferably, the ratio ranges between 3:1 and 1:10.

By using a composition comprising a mixture of a tetra-alkoxysilane and one or more hydrocarbylalkoxysilanes such as, e.g., aryl- or alkylalkoxysilanes, a stable layer is obtained that does not require a dehydroxylation aftertreatment. This aspect of the invention is based on the recognition that the formation of a silica network from the alkoxysilanes requires less than four alkoxy groups per silicon atom. Any remaining alkoxy groups and the silanol groups formed after hydrolysis render the silica network hydrophilic. In relation to tetra-alkoxysilane, the hydrocarbylalkoxysilane contains fewer alkoxy groups. On the other hand, said composition of tetra-alkoxysilane and hydrocarbylalkoxysilane comprises more hydrophobic hydrocarbyl groups. Some of these hydrocarbyl groups do not take part in forming the silica network. The hydrocarbyl groups have a hydrophobic, apolar character and preclude water adsorption in the porous silica network. Preferably the ratio is above 1:10. It has been found in an experiment that at a ratio above 1:10, the porous silica network is sufficiently stable to be used as a porous layer in an electric device. Even more stable layers are obtained at a ratio above 1:3.

The hydrophobic character of the surfaces in this case implies that essentially no water adsorption takes place up to an air humidity degree of approximately 50 percent. This is sufficient in actual practice since the air humidity degree in clean rooms is easily maintained between 40 and 50 percent. After manufacturing, e.g. during operation, the electric device may be exposed to a higher degree of air humidity, however, because an electric device is customarily encapsulated in a layer to protect it against moisture. With a decreasing ratio of tetra-alkoxysilane to hydrocarbylalkoxysilane the sensitivity to air humidity decreases until the layers are completely insensitive to air humidity. Preferably, the ratio is below 3:1. It has been found in an experiment that at a ratio above 3:1, the porous silica network is insufficiently hydrophobic and insufficiently mechanically stable to be used as a porous layer in an electric device. Preferably, the ratio is below 1:1. Preferably the ratio is above 2:3.

An advantage of the electric device in accordance with this embodiment resides in that the porous material has a substantially uniform pore size below 10 nm. By virtue of said pore size, the layer can suitably be used in an integrated circuit having very small elements of, e.g., 100 nm or 70 nm or 50 nm. If the size of the pores is of the order of the distance between the first conductor and the second conductor, short-circuits may occur between the first conductor and the second conductor, thereby bypassing the resistor, leading to a malfunctioning electric device.

An additional advantage of the electric device in accordance with this embodiment resides in that the porous material has a thermal expansion coefficient which is very similar to those of the materials commonly used as phase change material and as first conductor and second conductor. Therefore, the electric device has a large mechanical stability when the phase change material is heated.

In addition, the electric device can withstand heating to temperatures up to 400 degree Celsius during manufacturing of the electric device, which is advantageous because it allows the use of standard silicon processing technology. Furthermore, the porous material (substantially) does not react with other materials commonly used in silicon technology.

Favorable effects are achieved by using an hydrocarbylalkoxysilane wherein the hydrocarbyl group is selected among a methyl group, an ethyl group and a phenyl group. Some or all of the hydrocarbyl groups may be fluorinated, which has additional advantages. Such phenyl-, methyl- and ethylalkoxysilanes are thermally stable up to approximately 400 °C, allowing them to be calcinated in the customary manner. It is often advantageous to perform the heating in an atmosphere substantially free of oxygen. Preferably, the alkoxy group is a butoxy, propoxy, ethoxy or methoxy group.

The hydrocarbylalkoxysilane may additionally be a trihydrocarbylalkoxysilane, a dihydrocarbyldialkoxysilane and an hydrocarbyltrialkoxysilane. Particularly favorable examples are methyltrimethoxysilane, methyltriethoxysilane, phenyltrimethoxysilane, and phenyltriethoxysilane. By virtue of the crosslinking of the three alkoxy groups, such alkyltrialkoxysilanes are integrated very readily in to the silica network, and therefore, the stability of the network decreases hardly, if at all, in relation to a network obtained from pure tetra-alkoxysilane.

Particularly favorable results are obtained by using a composition comprising tetra-alkoxysilane and a methyltrimethoxysilane in a molar ratio of 1:1. By using such a composition, a porous layer is obtained having a low thermal conductivity and a high stability, even in humid conditions.

For the surfactant use may be made of cationic, anionic and non-ionic surfactants. Examples are, inter alia, cetyltrimethylammoniumbromide and cetyltrimethylammoniumchloride, triblock copolymers of polyethylene oxide, polypropylene oxide, and polyethylene oxide ethers, such as polyoxyethylene (10) stearyl ether.

Favorable results are achieved using a cationic surfactant in combination with a molar ratio of said surfactant to the totality of alkoxysilanes in excess of 0.1:1. Here, the totality of alkoxysilanes refers to the total amount of tetra-alkoxysilane and hydrocarbylalkoxysilane. In this manner, layers are achieved having a relatively low thermal conductivity. Unlike porous layers prepared from pure tetra-ethoxyorthosilicate (TEOS), the porous layers manufactured as described above remain stable, even if the composition comprises a high surfactant content. The resultant layers have a porosity above 45 percent and were found to be of good quality. Heating preferably takes place in an environment comprising oxygen, nitrogen and/or hydrogen.

Favorable results have also been achieved using a triblock copolymer comprising polyethylene oxide, polypropylene oxide and polyethylene oxide as the blocks serving as the surfactant. An example of such a surfactant is known by the name of Pluronic F127 which is a registered trademark of BASF of Ludwigshafen, Germany. The chemical composition of this surfactant is given in a data sheet published by BASF on the Internet. Low concentrations of this surfactant in the composition already lead to a porous layer having a high porosity and a correspondingly low thermal conductivity.

In a favorable embodiment of the electric device in accordance with the invention, the porous layer has a porosity above 45 percent. The advantage of a higher porosity is, in particular, a lower thermal conductivity. Here, the definition by the IUPAC is applied according to which porosity is the ratio of the total pore volume to the apparent volume of the layer. The IUPAC definition is described in J. Rouquérol et al., Pure and Applied Chemistry, volume 66, pages 1739-1758, published in 1994. This relatively high porosity may be obtained by a relatively high surfactant content in the composition described above. In the method in accordance with WO-A 00/39028, however, a larger amount of surfactant causes the layer formed to become unstable after calcination. Said instability means that the network of porous silica collapses, causing the porosity to decrease substantially from 55 to 28 percent.

It is advantageous if the resistor is embedded in the body, the layer being in direct contact with the resistor because in this case the heat flow out of the resistor is effectively reduced.

In an embodiment the first contact area is smaller than the second contact area, and the first conductor comprises a part in direct contact with the first contact area, the part being embedded in the layer. In this case the current density in the first contact area and in the part of the first conductor is higher than the current density in the second contact area. Therefore, the heating is more effective in the vicinity of the first contact area than in the vicinity of the second contact area. As a consequence, the phase change material close to the first contact area, in particular that in direct contact with the first contact area, is relatively easily melted. Heating for melting the phase change material close to the first contact area is achieved to a large extent by the first conductor and/or the contact resistance between the first conductor and the phase change material, in particular when the first conductor in the part close to the first contact area has a relatively poor conductivity. By embedding this part of the first conductor close to the first contact area in the layer, the switching power is reduced effectively because this part has a relatively high current density combined with a relatively low conductivity, corresponding to a high heating power. In this embodiment the heat flow out of this part of the first conductor to parts of the body free of the resistor, i.e. parts which do not contain the resistor, is reduced. The heat flow for heating the resistor is effectively directed towards the phase change material close to the first contact area.

In an embodiment of the electric device according to the invention, the first conductor, the second conductor, the resistor and the layer constitute a memory element, and the body comprises an array of memory cells, each memory cell comprising a respective memory element and a respective selection device, and a grid of select lines, each memory cell being individually accessible via the respective select lines connected to the respective selection device.

Such an electric device can be used as a non-volatile, electrically writable, electrically readable and electrically erasable memory. Because each memory cell comprises a selection device, individual memory elements can be conveniently selected for reading, i.e. for measuring the value of the electrical resistance, and for writing and erasing, i.e. for inducing a transition from a first phase to a second phase.

The memory elements of the present invention may be electrically coupled to selection devices and to selection lines in order to form a memory array. The selection devices permit each discrete memory cell to be read and written to without interfering with information stored in adjacent or remote memory cells of the array. Generally, the present invention is not limited to the use of any specific type of selection device. Examples of selection devices include field-effect transistors, bipolar junction transistors, and diodes such as known from, e.g., WO-A 97/07550. Examples of field-effect transistors include JFET and metal oxide semiconductor field effect transistors (MOSFET) such as known from, e.g., WO-A 00/39028. Examples of MOSFETs include NMOS transistors and PMOS transistors. Furthermore, NMOS and PMOS may even be formed on the same chip for CMOS technologies.

Usually, such types of electric devices are as compact as possible, which implies that the mutual distance between adjacent resistors is small. In these electric devices comprising a dielectric material according to the invention, crosstalk is reduced.

In one embodiment the selection device comprises a MOSFET having a source region, a drain region and a gate region, and the grid of select lines comprises N first select lines, M second select lines, N and M being integers, and an output line, the first conductor of each memory element being electrically connected to a first region selected from the source region and the drain region of the corresponding metal oxide semiconductor field effect transistor, the second conductor of each memory element being electrically connected to the output line, a second region of the corresponding metal oxide semiconductor field effect transistor which is selected from the source region and the drain region and which is free from the first region, being electrically connected to one of the N first select lines, the gate region being electrically connected to one of the M second select lines.

In this type of device the resistor can be conveniently integrated with the selection device.

These and other aspects of the electric device according to the invention will be further elucidated and described with reference to the drawings, in which:
Fig. 1 is a crosssection of an embodiment of the electric device; and
Fig. 2 is a crosssection of another embodiment of the electric device, and by means of some tables, in which
   - Table 1 shows embodiments of compositions by means of which porous materials are obtained;
   - Table 2 shows properties of the porous material obtained by using the embodiments 1-5 of Table 1; and
   - Table 3 shows properties of the porous material obtained by using the embodiments 6-11 of Table 1.

The Figures are not drawn to scale. In general, identical components are denoted by the same reference numerals.

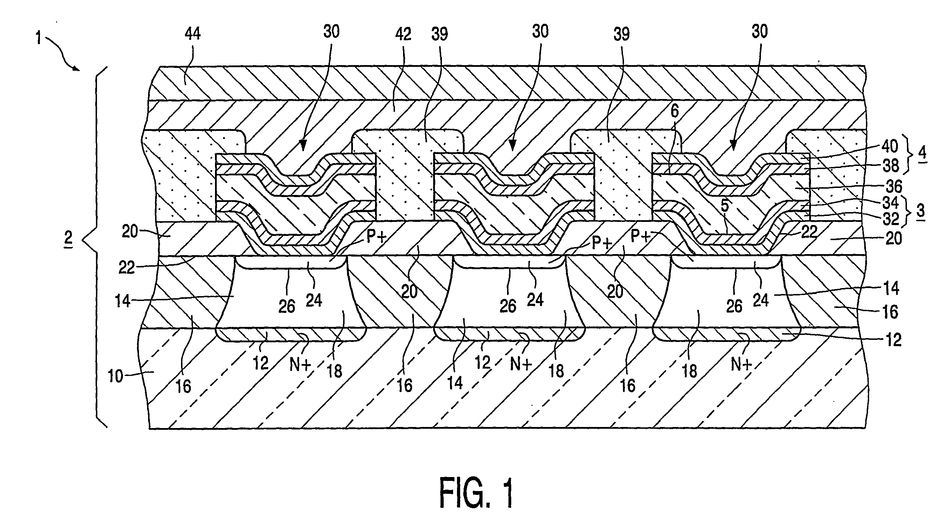

The electric device 1, shown in Fig. 1, has a construction similar to that described in WO-A 97/07550. It has a body 2 which comprises a plurality of resistors 36 each comprising a phase change material which is able to be in a first phase and in a second phase. In another embodiment not shown the body 2 comprises only one resistor 36. The phase change material is Te₈₁Ge₁₅S₂As₂. In another embodiment it is Te₈₁Ge₁₅S₂Sb₂. Alternatively, materials including Te, Ge, Sb and one or more transition metals TM in the ratio (TeₐGe_{b}Sb_{100-(a+b)})_{c}TM_{100-c} where the subscripts are in atomic percentages, a is below 70 percent, b is above 5 percent and below 50 percent and c is between 90 and 99.99 percent, may be used as the phase change material.

Each of the resistors 36 is embedded in the body 2 and has a surface with a first contact area 5 and a second contact area 6. The resistors 36 each have an electrical resistance between the respective first contact area 5 and the respective second contact area 6. The electrical resistances each have a first value when the phase change material is in the first phase and a second value when the phase change material is in the second phase.

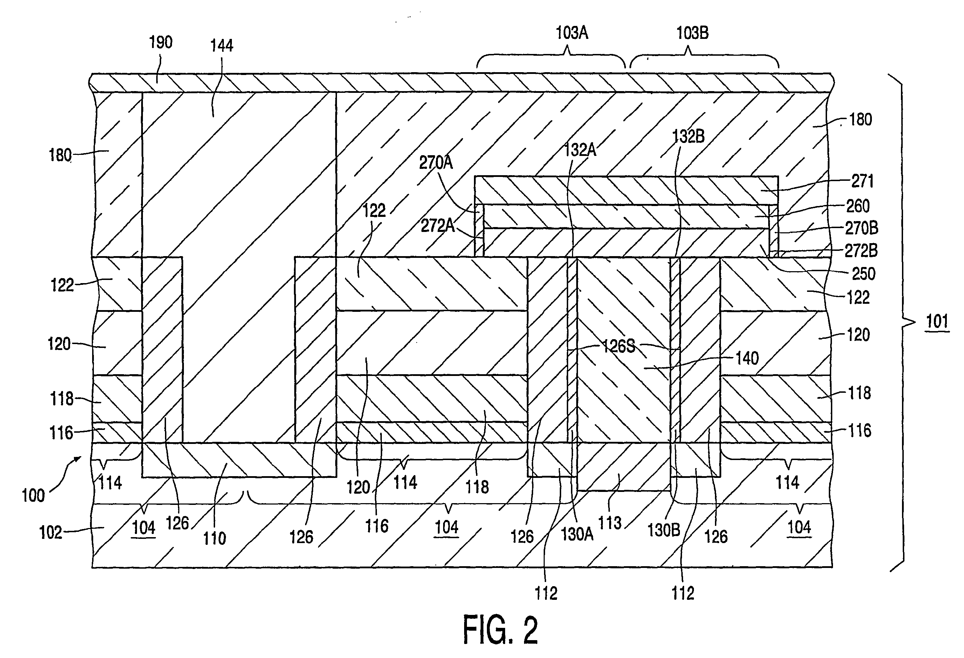

The body 2 comprises a single crystal silicon semiconductor wafer 10, which is a p-doped substrate. Formed in the p-substrate 10 are n+ channels 12, which extend across the wafer 10 in a direction perpendicular to the plane of Fig. 1 and which form one set of electrodes, in this case the y set, of an x-y grid of selection lines for addressing the individual memory elements 30. On top of this n+ grid structure is an n-doped crystalline epitaxial layer 14 which may be, e.g., about 500 nm thick and in which p-doped isolation channels 16 are formed. These p-doped isolation channels 16 extend all the way to the p-substrate 10 as shown in Fig. 1. They extend completely around islands 18 of the n-epitaxial layer 14, which islands in this way are defined and mutually isolated. The islands 18 are shown more clearly in the top view of Fig. 2 of WO-A 97/07550 wherein the p-isolation channels are shown as forming an isolation grid defining and isolating the islands 18 of n-epitaxial material. Instead of the p-doped isolation channels, layers of dielectric material may be used for isolation of the islands 18.

A layer 20 of dielectric material forms apertures 22 over the islands 18 which apertures 22 define diffusion regions 24 of p+ material. The junctions of the p+ regions and the n-epitaxial layer define p-n junction diodes in series with each of the regions of the n-epitaxial layer exposed through the apertures 22 of the layer 20. The p-n junction diodes serve as selection devices 26.

The memory elements 30 are deposited over the p+ regions 24 in individual electrical series contact with the selection devices 26. Each of the memory elements 30 comprises a first conductor 3 which is electrically connected to the first contact area 5 and which comprises a relatively thin electrical contact layer 32 of high corrosion resistance metal such as, e.g., molybdenum and an electrically conductive diffusion barrier layer 34 such as, e.g., carbon. The memory elements 30 each further comprise the resistor 36 formed of a phase change material as described above, and a second conductor 4, which is electrically connected to the second contact area 6 and comprises an upper thin electrical contact layer of high corrosion resistance material 40 of, e.g., molybdenum and an electrically conductive diffusion barrier layer 38 of, e.g., carbon. The contact layers 32, 34, 38 and 40 and the resistor 36 are identical to those described in WO-A 97/07550.

The first conductor 3, the second conductor 4 and the resistor 36 are able to conduct a current for heating of the phase change material to enable a transition from the first phase to the second phase, as is described in more detail above.

The layers 20 and 39 of a dielectric material which surround the lateral peripheral portions of the memory elements 30 thermally isolate the resistors 36 of the memory elements 30. This further confines, limits and controls the heat flow to parts of the body free of the resistor during the heating, thereby limiting the switching energy.

According to the invention, at least one of the layers 20 and 39 consists of a dielectric material comprising a porous material with pores having a size between 0.5 and 50 nm. Preferably, the pores have a size between 1 and 10 nm. In an embodiment the pores are substantially free of water. Preferably, at least layer 39, which is in direct contact with the resistor 36, consists of such a material. Different embodiments of such a porous material will be described below.

To manufacture the electric device 1 shown in Fig. 1, the layers 32, 34, 36, 38 and 40 are etched, the layer 39 is formed over said etched layers and subsequently etched to leave openings above the memory elements 30 as shown. Deposited on top of the entire structure formed by layers 32, 34, 36, 38, and 40 are selection lines 42 which form another set of electrodes, in this case the x set, of the x-y grid of selection lines for addressing the individual memory elements 30. The selection lines 42 may be made of, e.g. aluminum, tungsten or copper. The complete integrated structure is overlaid with an encapsulating layer 44 of a suitable encapsulant such as Si3N4 or a plastic material such as polyamide.

The body 2 thus comprises an array of memory cells, each of which comprises a respective memory element 30 and a respective selection device 26. The body 2 further comprises a grid of select lines 12 and 42 such that each memory cell is individually accessible via the respective select lines 12 and 42 connected to the respective selection device 26. A detailed description of this integrated circuit is known from WO-A 97/07550, see in particular Figs. 2-4.

The porous material may comprise porous silicon dioxide or any other porous dielectric material including, e.g., titanium oxide, vanadium oxide or zirconium oxide which has pores having a size between 0.5 and 50 nm. Preferably, the pores are substantially free of water. To this end, the porous silicon dioxide, titanium oxide, vanadium oxide or zirconium oxide is treated by, e.g., heat and/or in a vacuum to remove substantially all water present.

In an embodiment the pores have hydrophobic surfaces, which has the advantage that in this case it is possible to expose the electric device during manufacture to an atmosphere which comprises water vapor. Hydrophobic surfaces of the pores may be obtained, e.g., by using porous materials which are hydrophobic such as, e.g., porous SiLK™, which is marketed by Dow Chemical from Midland, Michigan, USA. Alternatively, a material as described in US-B1-6,352,945 and US-B1-6,383,955 may be used.

In another embodiment the porous material comprises an organosilicate which is not hydrophobic as such, and the pores are provided with hydrophobic surfaces by incorporating groups selected from alkyl groups and aryl groups in such a way into the matrix that the surfaces have at least some of these groups. In this embodiment the porous material is manufactured as is described in WO-A 00/39028. It is obtained from a composition comprising tetraethoxyorthosilicate and methyltriethoxysilane in a ratio of 0.85:0.15.

In another embodiment the porous material is obtained by applying a liquid layer of a composition comprising tetra-alkoxysilane, hydrocarbylalkoxysilane, a surfactant and a solvent onto a substrate, wherein the molar ratio between tetra-alkoxysilane and hydrocarbylalkoxysilane is 3:1 at the most, and removing the surfactant and the solvent by heating the liquid layer, while forming the hydrophobic porous layer.

A method to obtain this porous material is described in the unpublished patent application EP 01,203,536.6. To manufacture the electric device 1 according to this embodiment the layers 32, 34, 36, 38 and 40 are etched and the layer 39 is formed over said etched layers in the following way: the layers 20, 32, 34, 36, 38 and 40 are provided with a composition of tetra-alkoxysilane, hydrocarbylalkoxysilane, a surfactant and a solvent. Specific compositions are listed in Table 1, some of them will be discussed in detail below. For the solvent a mixture of alcohol, water and a small amount of acid is used. Suitable alcohols include, inter alia, methanol, ethanol, propanol and butanol. After drying and heating at 400 °C, the porous material 39 is formed. It has been found that the thickness of the layer formed depends on the number of revolutions during spin coating, the viscosity of the composition and the degree of dilution of the composition. If cetyltrimethylammoniumbromide (CTAB) is used as the surfactant, the pore size is 2-3 nm; if Pluronic F127 is used as the surfactant, the pore size is 7-8 nm. Measurements using X-ray diffraction and TEM equipment show that the pore size is substantially uniform. The properties of this layer depend on the composition, as listed in Table 2.

### Example 1

A composition of tetraethoxyorthosilicate (TEOS), methyltrimethoxysilane (MTMS), water and ethanol, which is acidified with HCl, is formed while stirring. The molar ratios of TEOS:MTMS:H₂O:ethanol:HCl are 0.5:0.5:1:3:5.10⁻⁵. This composition was heated to 60 °C for 90 minutes. Water, ethanol, HCl and cetyltrimethylammoniumbromide (CTAB) were added to this pre-treated composition to obtain a molar ratio of TEOS:MTMS:H₂O:ethanol:HCl:CTAB of 0.5:0.5:7.5:20:0.006:0.10. The composition was stirred for three days at room temperature. Subsequently, the composition is provided by means of spin coating at 1000 rpm for 1 minute in a KarlSuss CT62 spin coater. The layer is dried at 130 °C for 10 minutes on a hot plate and subsequently heated to 400 °C for 1 hour in air. In this manner a porous layer having a thickness of 200-400 nm is obtained having a relative dielectric constant of 2.4 and a porosity of 44%, as listed in Table 2.

In this case, the dielectric constant is measured by means of a mercury probe (type Hg-612 from MSI electronics) at a frequency of 1 MHz. The porosity is determined in at least one of the two following ways known to persons skilled in the art: on the basis of the refractive index and by means of a layer thickness measurement and Rutherford back scattering (RBS). The refractive index is determined through ellipsometry using a VASE ellipsometer VB-250, JA Woolam Co, Inc. From this value the porosity is determined via a Bruggeman effective medium approximation with a depolarization factor of 0.33.

### Example 2

A composition of TEOS, MTMS, water, ethanol, HCl and CTAB is prepared, in which the amount of surfactant is increased, as compared to example 1, to 0.22. In this embodiment the surfactant is a cationic surfactant, and the surfactant and the totality of alkoxysilanes are present in a molar ratio greater than 0.1:1. The composition is treated in the manner described in example 1. This leads to an electric device 1 in which the porous material has a porosity above 45 percent, the porous material having a porosity of 56%.

### Example 3

The composition of example 2 is stirred for three days at room temperature. Subsequently, the composition is provided by means of spin coating at 1000 rpm for 1 minute in a KarlSuss CT62 spin coater. The layer is dried at 130 °C for 10 minutes and subsequently heated to 400 °C for 1 hour in a gas mixture comprising 93 vol.% N₂ and 7 vol.% H₂.
TEOS = tetraethoxyorthosilicate
HCAS = hydrocarbylalkoxysilane
CTAB = cetyltrimethylammoniumbromide
MTMS = methyltrimethoxysilane
PhTES = phenyltriethoxysilane
F127 = Pluronic F127, a triblock polymer comprising polyethylene oxide, polypropylene oxide and polyethylene oxide as the blocks;
Brij76 = polyoxyethylene (10) stearyl ether, C₁₈H₃₇(OCH₂CH₂)ₙOH, n ≈ 10
DMDES = dimethyldiethoxysilane

**Table 1, compositions, way of applying and heating. The Figures listed indicate the molar ratios.**

| no | TEOS | HCAS | surfactant | HCl -10⁻³ | H₂O | EtOH | application | heating for 1 hour |
|---|---|---|---|---|---|---|---|---|
| 1 | 0.75 | MTMS, | CTAB, | 4 | 5 | 20 | dipping | 400 °C |
| | | 0.25 | 0.08-0.14 | | | | | in air |
| 2 | 0.75 | PhTES, | CTAB, | 4 | 5 | 20 | Spin | 350 °C |
| | | 0.25 | 0.1 | | | | coating | in air |
| 3 | 0.5 | MTMS, | CTAB | 6 | 7.5 | 20 | Spin | 400 °C |
| | | 0.5 | 0.10-0.22 | | | | coating | in air |
| 4 | 0.5 | MTMS, | CTAB | 6 | 7.5 | 20 | Spin | 400 °C |
| | | 0.5 | 0.10-0.22 | | | | coating | in 7%H₂ in N₂ |
| 5 | 0.5 | MTMS, | F127, | 4 | 5 | 20 | dipping | 400 °C |
| | | 0.5 | 0.0052 | | | | | in air |
| 6 | 0.5 | MTMS, | F127, | 4 | 5 | 20 | Spin | 400 °C |
| | | 0.5 | 0.006 | | | | coating | in air |
| 7 | 0.5 | MTMS, | F127, | 4 | 5 | 10 | Spin | 400 °C |
| | | 0.5 | 0.006 | | | | coating | in air |
| 8 | 0.5 | MTMS, | CTAB, | 4 | 5 | 20 | Spin | 400 °C |
| | | 0.5 | 0.10 | | | | coating | in air |
| 9 | 0.5 | MTMS, | Brij 76, | 4 | 5 | 20 | Spin | 400 °C |
| | | 0.5 | 0.14 | | | | coating | in air |
| 10 | 0.67 | DMDES, | CTAB, | 4 | 5 | 20 | Spin | 400 °C |
| | | 0.33 | 0.18 | | | | coating | in air |
| 11 | 0.67 | DMDES, | CTAB, | 4 | 5 | 20 | Spin | 400 °C |
| | | 0.33 | 0.18 | | | | coating | in 7% H₂, in N₂ |

**Table 2 - Porosity of the porous layers prepared using the compositions 1-5 with varying quantities of surfactant. Unless indicated otherwise, the surfactant used is CTAB.**

| no | surfactant concentration | porosity |
|---|---|---|
| 1 | 0.08 | 45% |
| | 0.10 | 49% |
| | 0.12 | 54% |
| | 0.14 | 53% |
| 2 | 0.1 | 45% |
| 3 | 0.10 | 44% |
| | 0.13 | 50% |
| | 0.16 | 53% |
| | 0.19 | 53% |
| | 0.22 | 56% |
| 4 | 0.10 | 45% |
| | 0.16 | 54% |
| | 0.22 | 56% |
| 5 | F127/0.0052 | 54% |

**Table 3 - Layer thickness and porosity of the porous layers prepared using the compositions 6-11 at a varying number of revolutions during spin coating.**

| no | rpm during spin coating | layer thickness (nm) | porosity |
|---|---|---|---|
| 6 | 1000 rpm | 692 | 54% |
| | 750 rpm | 851 | 57% |
| | 500 rpm | 1030 | 57% |
| 7 | 1000 rpm | 1545 | 59% |
| | 750 rpm | 1802 | 60% |
| 8 | 1000 rpm | 409 | 46% |
| | 750 rpm | 473 | 46% |
| | 500 rpm | 568 | 46% |
| 9 | 1000 rpm | 494 | 59% |
| 10 | 1000 rpm | 441 | 53% |
| 11 | 1000 rpm | 438 | 51% |

In another embodiment the electric device 100 shown in Fig. 2 is similar to that known from WO-A 00/57498. The electric device 100 is formed on a semiconductor substrate 102 which may be, e.g., p-doped silicon forming a p-substrate for the deposition of the remaining elements of the configuration illustrated. Alternatively, the substrate may be a monocrystalline GaAs wafer or a glass substrate. It comprises an N x M array of memory cells identical to that known from WO-A 00/57498, see in particular Fig. 4 of that patent application. Here, N and M are integers. Each memory cell comprises a respective memory element 103 and a respective selection device 104. In the embodiment shown in Fig. 2 each memory cell comprises two independent memory elements 103A and 103B. The first conductor 130A, the second conductor 270A, the resistor 250 and the layers 126, 140 and 260 of dielectric material constitute memory element 103A, and the first conductor 130B, the second conductor 270B, the resistor 250 and the layers 126, 140 and 260 constitute memory element 103B. In other words, the memory elements 103A and 103B share the same resistor 250 and the same layers 126, 140 and 260.

The resistor 250, which may comprise a phase change material as described above, has a surface with first contact areas 132A and 132B, and second contact areas 272A and 272B, respectively. As part of memory element 103A, the resistor 250 has an electrical resistance between the first contact area 132A and the second contact area 272A which has a first value when the phase change material is in the first phase and a second value when the phase change material is in the second phase. As part of memory element 103B, the resistor 250 has an electrical resistance between the first contact area 132B and the second contact area 272B which has a first value when the phase change material is in the first phase and a second value when the phase change material is in the second phase. The first conductors 130A and 130B, which may comprise, e.g., the same materials as the first conductor 3 described above, are electrically connected to the first contact areas 132A and 132B, respectively. The second conductors 270A and 270B, which may comprise, e.g., the same materials as the second conductor 4 described above, are electrically connected to the second contact areas 272A and 272B, respectively. The first conductor 130A, the second conductor 270A and the resistor 250 are able to conduct a current for heating of the phase change material to enable a transition from the first phase to the second phase, thereby changing the electrical resistance of the first memory element 103A. Analogously, the first conductor 130B, the second conductor 270B and the resistor 250 are able to conduct a current for heating of the phase change material to enable a transition from the first phase to the second phase, thereby changing the electrical resistance of the second memory element 103B.

As shown in the embodiment shown in Fig. 2, a layer 260 of a dielectric material provides for electrical isolation between the resistor 250 and the output line 271 such that the resistor 250 is connected to the output line 271 only via the second conductors 270A and 270B. The dielectric layer 260 also provides a thermal blanket for reducing a heat flow to parts of the body 101 free of the resistor 250 during the heating. The dielectric layer 140 electrically isolates the first conductor 130A from the first conductor 130B. A dielectric layer 180 which may comprise borophosphosilicate glass (BPSG) is deposited on top of the electric device 100.

Analogous to the electric device known from WO-A 00/57498, the first conductors 130A and 130B are conductive sidewall spacers, also referred to as conductive spacers, formed along the sidewall surfaces 126S of the dielectric regions 126. The area of contact between the resistor 250 and the first conductors 130A and 130B are the first contact area 132A and 132B, respectively. Hence, the only electrical coupling between the resistor 250 and the first conductors 130A and 130B is through all or a portion of the first contact area 132A and 132B, respectively. The remainder of the first conductors 130A and 130B is electrically isolated from the resistor 250 by dielectric layers 126 and 140.

Alternatively, the first conductor 130A and/or 130B may be formed as conductive sidewall spacers by conformally depositing one or more contact layers onto the sidewall surface or surfaces of a via hole as known from WO-A 00/57498. The via hole may be round, square, rectangular or irregularly shaped. The conductive sidewall spacers may also be formed by conformally depositing one or more contact layers onto the sidewall surfaces of a pillar or mesa. The remaining space in the via is filled with a layer of dielectric material, preferably comprising a porous material with pores free of water. Embodiments of this material have been described above.

According to the invention, at least one of the layers 126, 140, 180 and 260 consists of a dielectric material comprising a porous material with pores having a size between 0.5 and 50 nm. In this way, the heat flow to parts of the body 101 free of the resistor 250 is reduced, resulting in a reduced switching power. Preferably, at least one of the layers 126, 140 and 260, which are in direct contact with the resistor 250, consists of such a material. Preferably, the pore size is between 1 and 10 nm. In a preferred embodiment the pores are substantially free of water. Different embodiments of the porous material have been described above.

In the embodiment of Fig. 2 the first contact areas 132A and 132B are smaller than the corresponding second contact areas 272A and 272B, respectively. The first conductors 130A and 130B each comprise a part in direct contact with the first contact area 132A and 132B, respectively. Preferably, this part is embedded in layers 126 and 140 which comprise porous material with pores substantially free of water because in this case the heat flow to parts of the body 101 free of the resistor 250 is reduced particularly effectively. Due to the relatively small first contact areas 132A and 132B, the current density within the part of the first conductors 130A and 130B is particularly large, causing increased Joule heating adjacent the resistor 250. The effect of this heating on enabling the phase transition is particularly large due to the improved thermal insulation.

The body 101 comprises a grid of select lines comprising N first select lines 190, M second select lines120 and an output line 271 such that each memory cell is individually accessible via the respective select lines 120 and 190 connected to the respective selection device 104. Each of the memory elements 103A and 103B of electric device 100 is electrically coupled to a selection device 104 which is a MOSFET, and more specifically an NMOS transistor. The MOSFET has n-doped source regions 110, n-doped drain regions 112, and gate regions 118. The source regions 110 and the drain regions 112 may comprise more than one portion of n-doped material, namely a lightly doped n-portion and a more heavily doped n+ portion.

The n-doped source regions 110 and drain regions 112 are separated by channel regions 114. The gate regions 118, formed above the channel regions 114, control the flow of current from the source regions 110 to the drain regions 112 through the channel regions 114. The gate regions 118 preferably comprise a layer of polysilicon. The gate regions 118 are separated from the channel regions 114 by dielectric regions 116.

Channel stop regions 113 are formed in the n-doped drain regions 112, creating two neighboring, electrically isolated drain regions 112 for separate NMOS transistors. Generally, the channel stop regions 113 have a conductivity type opposite that of the source regions 110 and the drain regions 112. In the NMOS embodiment shown, the channel stop region 113 comprises p-doped silicon.

Select lines 120 are formed above the gate regions 118, which select lines preferably comprise a layer of tungsten silicide. Select lines 120 are used to deliver the electrical signal to the gate regions 118. The dielectric regions 122 are formed above the select lines 120, said dielectric regions preferably comprising a porous material with pores substantially free of water. The dielectric regions 122 electrically insulate the select lines 120 from neighboring regions of the electric device 100. The stacks of layers 116, 118, 120 are collectively referred to as the gate stacks. Dielectric regions 126 are formed on the sidewall surfaces of the gate stacks.

Select lines 190 are formed on top of the upper insulation regions 180. The select lines 190 may be formed from a conductive material such as aluminum or copper. Tungsten plugs 144 electrically connect the select lines 190 to the source regions 110. It is noted that in the particular embodiment shown in Fig. 2, two NMOS transistors share each of the tungsten plugs 144. A layer of titanium silicide (not shown) may be formed on the surface of the silicon substrate to improve the conductivity between the substrate 102 and the conductive sidewall spacers 130A and 130B as well as between the substrate 102 and the conductive plugs 144. The conductive plugs 144 are electrically insulated from the gate stacks by dielectric layers 126.

The first conductors 130A and 130B of memory element 103A and 103B, respectively, are electrically connected to a first region selected from the source region 110 and the drain region 112 of the corresponding metal oxide semiconductor field effect transistor. In the embodiment of Fig. 2 the first region is the drain region 112. The second conductor 270 of each memory element 103A and 103B is electrically connected to the output line 271, which may comprise, e.g., the same material as the second conductor 270. A second region of the corresponding metal oxide semiconductor field effect transistor which is selected from the source region 110 and the drain region 112 and which is free from the first region, is electrically connected to one of the N first select lines 190. The gate region 118 is electrically connected to one of the M second select lines 120.

In summary, the electric device 1,100 comprises a resistor 36, 250 comprising a phase change material which is able to be in a first phase and in a second phase. The resistor 36, 250 has an electrical resistance which has a first value when the phase change material is in the first phase and a second value when the phase change material is in the second phase. The resistor 36, 250 is electrically connected to a first conductor 3, 130A, 130B and a second conductor 4, 270, which are able to conduct a current for heating of the phase change material to enable a transition from the first phase to the second phase. The electric device 1,100 further comprises a layer 20, 39, 126, 140, 260 of a dielectric material for reducing a heat flow to parts of the body 2, 101 free of the resistor 36, 250 during the heating, which dielectric material according to the invention comprises a porous material with pores having a size between 0.5 and 50 nm.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements.

## Claims

1. An electric device (1, 100) with a body (2, 101) having:
- a resistor (36, 250) comprising a phase change material which is able to be in a first phase and in a second phase, the resistor (36, 250) having a surface with a first contact area (5, 132) and a second contact area (6, 272), the resistor (36, 250) having an electrical resistance between the first contact area (5, 132) and the second contact area (6, 272), the electrical resistance having a first value when the phase change material is in the first phase and a second value when the phase change material is in the second phase,
- a first conductor (3, 130) electrically connected to the first contact area (5, 132),
- a second conductor (4, 270) electrically connected to the second contact area (6, 272),
- the first conductor (3, 130), the second conductor (4, 270) and the resistor (36, 250) being able to conduct a current for heating of the phase change material to enable a transition from the first phase to the second phase, and
- a layer (20, 39, 126, 140, 260) of a dielectric material, which is not comprised in the resistor (36, 250), for reducing a heat flow to parts of the body (2, 101) free of the resistor (36, 250) during the heating, **characterized in that** the dielectric material comprises a porous material with pores having a size between 0.5 nm and 50 nm.

2. An electric device (1, 100) as claimed in claim 1, wherein the pores have a size between 1 nm and 10 nm.

3. An electric device (1, 100) as claimed in claim 1, wherein the pores are substantially free of water.

4. An electric device (1, 100) as claimed in claim 1, wherein the pores have hydrophobic surfaces.

5. An electric device (1, 100) as claimed in claim 4, wherein the porous material comprises an organosilicate and the hydrophobic surfaces have hydrocarbyl groups.

6. An electric device (1, 100) as claimed in claim 5, wherein the porous material is obtainable by
- applying a liquid layer of a composition comprising tetra-alkoxysilane, hydrocarbylalkoxysilane, a surfactant and a solvent onto a substrate, wherein the molar ratio between tetra-alkoxysilane and hydrocarbylalkoxysilane is 3:1 at the most, and
- heating the liquid layer to remove the surfactant and the solvent and to form the hydrophobic porous layer.

7. An electric device (1, 100) as claimed in claim 6, **characterized in that** the surfactant is a cationic surfactant, and the surfactant and the totality of alkoxysilanes are present in a molar ratio greater than 0.1:1.

8. An electric device (1, 100) as claimed in claim 1, **characterized in that** the porous material has a porosity above 20 percent.

9. An electric device (1, 100) as claimed in claim 1, **characterized in that** the resistor (36, 250) is embedded in the body (2, 101), the layer (39, 126, 140, 260) being in direct contact with the resistor (36, 250).

10. An electric device (100) as claimed in claim 9, **characterized in that** the first contact area (132) is smaller than the second contact area (272), and the first conductor (130) comprises a part in direct contact with the first contact area (132), the part being embedded in the layer (126, 140).

11. An electric device (1, 100) as claimed in claim 1, **characterized in that** the first conductor (3, 130), the second conductor (4, 270), the resistor (36, 250) and the layer (20, 39, 126, 140, 260) constitute a memory element (30, 103), and the body (2, 101) comprises:
- an array of memory cells, each memory cell comprising a respective memory element (30, 103) and a respective selection device (26, 104), and
- a grid of select lines (12, 42, 120, 190), each memory cell being individually accessible via the respective select lines (12, 42, 120, 190) connected to the respective selection device (26, 104).

12. An electric device (100) as claimed in claim 11, **characterized in that**:
- the selection device (104) comprises a metal oxide semiconductor field effect transistor having a source region (110), a drain region (112) and a gate region (116), and
- the grid of select lines comprises N first select lines (190), M second select lines (120), N and M being integers, and an output line (271),
the first conductor (130) of each memory element (103) being electrically connected to a first region selected from the source region (110) and the drain region (112) of the corresponding metal oxide semiconductor field effect transistor, the second conductor (270) of each memory element (103) being electrically connected to the output line (271), a second region of the corresponding metal oxide semiconductor field effect transistor which is selected from the source region (110) and the drain region (112) and which is free from the first region, being electrically connected to one of the N first select lines (190), the gate region (116) being electrically connected to one of the M second select lines (120).

## Patentansprüche

1. Elektrische Anordnung (1, 100) mit einem Körper (2, 101) mit:
- einem Widerstand (36, 250), der ein Phasenänderungsmaterial umfasst, das fähig ist, in einer ersten Phase und in einer zweiten Phase zu sein, wobei der Widerstand (36, 250) eine Oberfläche mit einer ersten Kontaktfläche (5, 132) und eine zweite Kontaktfläche (6, 272) hat, der Widerstand (36, 250) einen elektrischen Widerstand zwischen der ersten Kontaktfläche (5, 132) und der zweiten Kontaktfläche (6, 272) hat, der elektrische Widerstand einen ersten Wert hat, wenn das Phasenänderungsmaterial in der ersten Phase ist und einen zweiten Wert hat, wenn das Phasenänderungsmaterial in der zweiten Phase ist,
- einem an die erste Kontaktfläche (5, 132) elektrisch angeschlossenen ersten Leiter (3, 130),
- einem an die zweite Kontaktfläche (6, 272) elektrisch angeschlossenen zweiten Leiter (4, 270),
- wobei der erste Leiter (3, 130), der zweite Leiter (4, 270) und der Widerstand (36, 250) fähig sind, einen Strom zum Erhitzen des Phasenänderungsmaterials zu leiten, um einen Übergang aus der ersten Phase in die zweite Phase zu ermöglichen, und
- einer Schicht (20, 39, 126, 140, 260) eines dielektrischen Materials, die nicht in dem Widerstand (36, 250) enthalten ist, um während des Erhitzens einen Wärmefluss zu Teilen des Körpers (2, 101), die frei von dem Widerstand (36, 250) sind, zu reduzieren, **dadurch gekennzeichnet, dass** das dielektrische Material ein poröses Material mit Poren einer Größe zwischen 0,5 nm und 50 nm umfasst.

2. Elektrische Anordnung (1, 100) nach Anspruch 1, worin die Poren eine Größe zwischen 1 nm und 10 nm haben.

3. Elektrische Anordnung (1, 100) nach Anspruch 1, worin die Poren im Wesentlichen wasserfrei sind.

4. Elektrische Anordnung (1, 100) nach Anspruch 1, worin die Poren hydrophobe Oberflächen haben.

5. Elektrische Anordnung (1,100) nach Anspruch 4, worin das poröse Material ein Organosilikat umfasst und die hydrophoben Oberflächen Hydrocarbyl-Gruppen haben.

6. Elektrische Anordnung (1, 100) nach Anspruch 5, worin das poröse Material durch Folgendes gewonnen werden kann:
- Aufbringen einer flüssigen Schicht mit einer Zusammensetzung, die Tetra-Alkoxysilan, Hydrocarbyl-Alkoxysilan, ein Tensid und ein Lösungsmittel umfasst, auf ein Substrat, wobei das Molverhältnis zwischen Tetra-Alkoxysilan and Hydrocarbyl-Alkoxysilan höchstens 3:1 ist, und
- Erhitzen der flüssigen Schicht, um das Tensid und das Lösungsmittel zu entfernen und um die hydrophobe poröse Schicht zu bilden.

7. Elektrische Anordnung (1, 100) nach Anspruch 6, **dadurch gekennzeichnet, dass** das Tensid ein kationisches Tensid ist, und das Tensid und die Gesamtheit der Alkoxysilane in einem Molverhältnis größer als 0,1: 1 vorhanden sind.

8. Elektrische Anordnung (1,100) nach Anspruch 1, **dadurch gekennzeichnet, dass** das poröse Material eine Porosität über 20 Prozent hat.

9. Elektrische Anordnung (1, 100) nach Anspruch 1, **dadurch gekennzeichnet, dass** der Widerstand (36, 250) in den Körper (2, 101) eingebettet ist, wobei die Schicht (39, 126, 140, 260) in direktem Kontakt mit dem Widerstand (36, 250) steht.

10. Elektrische Anordnung (100) nach Anspruch 9, **dadurch gekennzeichnet, dass** die erste Kontaktfläche (132) kleiner als die zweite Kontaktfläche (272) ist, und der erste Leiter (130) einen Teil in direktem Kontakt mit der ersten Kontaktfläche (132) umfasst, wobei der Teil in die Schicht (126, 140) eingebettet ist.

11. Elektrische Anordnung (1, 100) nach Anspruch 1, **dadurch gekennzeichnet, dass** der erste Leiter (3, 130), der zweite Leiter (4, 270), der Widerstand (36, 250) und die Schicht (20, 39, 126, 140, 260) ein Speicherelement (30, 103) bilden, und Körper (2, 101) Folgendes umfasst:
- eine Matrix von Speicherzellen, wobei jede Speicherzelle ein jeweiliges Speicherelement (30, 103) und eine jeweilige Ansteueranordnung (26, 104) umfasst, und
- ein Raster von Ansteuerleitungen (12, 42, 120, 190),
wobei jede Speicherzelle individuell über die jeweiligen Ansteuerleitungen (12, 42, 120, 190), die an die jeweilige Ansteueranordnung (26, 104) angeschlossen sind, zugänglich ist.

12. Elektrische Anordnung (100) nach Anspruch 11, **dadurch gekennzeichnet, dass**:
- die Ansteueranordnung (104) einen Metalloxidhalbleiter-Feldeffekttransistor mit einem Sourcegebiet (110), einem Draingebiet (112) und einem Gategebiet (116) umfasst, und
- das Raster der Ansteuerleitungen N erste Ansteuerleitungen (190), M zweite Ansteuerleitungen (120), mit ganzzahligen N und M, und eine Ausgangsleitung (271) umfasst,
wobei der erste Leiter (130) jedes Speicherelements (103) elektrisch an ein erstes, aus dem Sourcegebiet (110) und dem Draingebiet (112) des entsprechenden Metalloxidhalbleiter-Feldeffekttransistors ausgewählten Gebiet angeschlossen ist, der zweite Leiter (270) jedes Speicherelements (103) elektrisch an die Ausgangsleitung (271) angeschlossen ist, ein zweites Gebiet des entsprechenden Metalloxidhalbleiter-Feldeffekttransistors, das aus dem Sourcegebiet (110) und dem Draingebiet (112) ausgewählt ist und das frei von dem ersten Gebiet ist, elektrisch an eine der N ersten Ansteuerleitungen (190) angeschlossen ist, und das Gategebiet (116) elektrisch an eine der M zweiten Ansteuerleitungen (120) angeschlossen ist.

## Revendications

1. Dispositif électrique (1, 100) avec un corps (2, 101) ayant :
- un élément résistif (36, 250) comprenant un matériau à changement de phase qui est capable d'être dans une première phase et dans une deuxième phase, l'élément résistif (36, 250) ayant une surface avec une première zone de contact (5, 132) et une deuxième zone de contact (6, 272), l'élément résistif (36, 250) ayant une résistance électrique entre la première zone de contact (5, 132) et la deuxième zone de contact (6, 272), la résistance électrique ayant une première valeur lorsque le matériau à changement de phase est dans la première phase et une deuxième valeur lorsque le matériau à changement de phase est dans la deuxième phase,
- un premier conducteur (3, 130) raccordé électriquement à la première zone de contact (5, 132),
- un deuxième conducteur (4, 170) raccordé électriquement à la deuxième zone de contact (6, 272),
- le premier conducteur (3, 130), le deuxième conducteur (4, 270) et l'élément résistif (36, 250) étant capables de conduire un courant pour le chauffage du matériau à changement de phase pour générer une transition de la première phase à la deuxième phase, et
- une couche (20, 39, 126, 140, 260) d'un matériau diélectrique, qui n'est pas compris dans l'élément résistif (36, 250), pour réduire le flux de chaleur vers les parties du corps (2, 101) exemptes de l'élément résistif (36, 250) pendant le chauffage, **caractérisée en ce que** le matériau diélectrique comprend un matériau poreux avec des pores ayant une dimension entre 0,5 nm et 50 nm.

2. Dispositif électrique (1, 100) selon la revendication 1, dans lequel les pores ont une dimension entre 1 nm et 10 nm.

3. Dispositif électrique (1, 100) selon la revendication 1, dans lequel les pores sont substantiellement exempts d'eau.

4. Dispositif électrique (1, 100) selon la revendication 1, dans lequel les pores ont des surfaces hydrophobes.

5. Dispositif électrique (1, 100) selon la revendication 4, dans lequel le matériau poreux comprend un silicate organique et que les surfaces hydrophobes ont des groupes hydrocarbyle.

6. Dispositif électrique (1, 100) selon la revendication 5, dans lequel le matériau poreux peut être obtenu par
- application d'une couche liquide d'une composition comprenant du tétra-alkoxysilane, de l'hydrocarbylalkoxysilane, un tensioactif et un solvant sur un substrat, dans lequel le rapport molaire entre le tétra-alkoxysilane et l'hydrocarbylalkoxysilane est de 3:1 au plus, et
- chauffage de la couche liquide pour retirer le tensioactif et le solvant et former la couche poreuse hydrophobe.

7. Dispositif électrique (1, 100) selon la revendication 6, **caractérisé en ce que** le tensioactif est un tensioactif cationique, et que le tensioactif et la totalité des alkoxysilanes sont présents dans un rapport molaire plus grand que 0,1 :1.

8. Dispositif électrique (1, 100) selon la revendication 1, **caractérisé en ce que** le matériau poreux a une porosité supérieure à 20 pour cent.

9. Dispositif électrique (1, 100) selon la revendication 1, **caractérisé en ce que** l'élément résistif (36, 250) est noyé dans le corps (2, 101), la couche (39, 126, 140, 260) étant en contact direct avec l'élément résistif (36, 250).

10. Dispositif électrique (1, 100) selon la revendication 9, **caractérisé en ce que** la première zone de contact (132) est plus petite que la deuxième zone de contact (272), et que le premier conducteur (130) comprend une partie en contact direct avec la première zone de contact (132), la partie étant noyée dans la couche (126, 140).

11. Dispositif électrique (1, 100) selon la revendication 1, **caractérisé en ce que** le premier conducteur (3, 130), le deuxième conducteur (4, 270), l'élément résistif (36, 250) et la couche (20, 39, 126, 140, 260) constitue un élément de mémoire (30, 103) et que le corps (2, 101) comprend :
- une matrice de cellules mémoire, chaque cellule mémoire comprenant un élément de mémoire respectif (30, 103) et un dispositif de sélection respectif (26, 104), et
- une grille de lignes de sélection (12, 42, 120, 190), chaque cellule mémoire étant individuellement accessible via les lignes de sélection respectives (12, 42, 120, 190) raccordées au dispositif de sélection respectif (26, 104).

12. Dispositif électrique (100) selon la revendication 11, **caractérisé en ce que** :
- le dispositif de sélection (104) comprend un transistor à effet de champ semi-conducteur à métal oxyde ayant une région source (110), une région drain (112) et une région de grille (116) et que
- la grille de lignes de sélection comprend N premières lignes de sélection (190), M deuxièmes lignes de sélection (120), N et M étant des nombres entiers, et une ligne de sortie (271),
le premier conducteur (130) de chaque élément de mémoire (103) étant raccordé électriquement à une première région sélectionnée entre la région source (110) et la région drain (112) du transistor à effet de champ semi-conducteur à métal oxyde correspondant, le deuxième conducteur (270) de chaque élément de mémoire (103) étant raccordé électriquement à la ligne de sortie (271), une deuxième région du transistor à effet de champ semi-conducteur à métal oxyde correspondant qui est sélectionnée entre la région source (110) et la région drain (112) et qui est indépendante de la première région, étant électriquement raccordée aux N premières lignes de sélection (190), la région de grille (116) étant électriquement raccordée à l'une des M deuxièmes lignes de sélection (120).
